Europäisches Patentamt

European Patent Office

Office européen des brevets

(19)

(11) Numéro de publication : **0 063 980**
**B1**

(12) **FASCICULE DE BREVET EUROPÉEN**

(45) Date de publication du fascicule du brevet :
26.06.85

(21) Numéro de dépôt : 82400636.5

(22) Date de dépôt : 06.04.82

(51) Int. Cl.⁴ : **G 02 B 27/40**, G 03 B 41/00,
**G 02 B 7/11**

(54) **Appareil de projection à dispositif de mise au point.**

(30) Priorité : 16.04.81 FR 8107709

(43) Date de publication de la demande :
03.11.82 Bulletin 82/44

(45) Mention de la délivrance du brevet :
26.06.85 Bulletin 85/26

(84) Etats contractants désignés :
CH DE GB IT LI NL

(56) Documents cités :
EP-A- 0 031 680
FR-A- 2 187 129
FR-A- 2 445 512
GB-A- 2 052 090
US-A- 3 517 992
SOLID STATE TECHNOLOGY, vol.23, no.6, juin 1980,
Port Washington, N.Y. (US), S. WITTEKOEK: "Step-
and-repeat wafer imaging", pages 80-84

(73) Titulaire : **MATRA GCA S.A.**
**4, rue de Presbourg**
**F-75116 Paris (FR)**

(72) Inventeur : **Berger, Laurent**
**31, Avenue de la Plaine Fleurie**
**F-38240 Meylan (FR)**
Inventeur : **Tigreat, Paul**
**19, Allée des Mitaillères**
**F-38240 Meylan (FR)**

(74) Mandataire : **Fort, Jacques et al**
**CABINET PLASSERAUD 84, rue d'Amsterdam**
**F-75009 Paris (FR)**

EP 0 063 980 B1

# Description

La présente invention a pour objet un appareil de projection sur une surface image à l'aide d'une optique du type comportant un dispositif de mise au point muni d'un jeu de moyens de détection des écarts entre la surface image et une position nominale par rapport à l'optique, ce jeu ayant des moyens solidaires de l'optique pour former, sur ladite surface, une tache de lumière monochromatique en incidence oblique et des moyens de reprise de la lumière provenant de ladite surface pour former de la tache une image qui est centrée sur un photodétecteur différentiel lorsque la surface occupe sa position nominale par rapport à l'optique.

L'invention trouve une application particulièrement importante dans les appareils utilisés pour la fabrication des circuits intégrés, et notamment dans ceux, connus sous le nom de « photorépéteurs sur tranche », destinés à former de façon répétitive l'image d'un réticule ou masque dans des zones successives de la surface d'une tranche de semi-conducteur.

Il est nécessaire de maintenir la distance entre l'optique, qui constitue l'objectif du photorépéteur, et la surface image sous peine de dégradation de celle-ci. A titre d'exemple, on peut mentionner que la distance entre objectif et surface image est de 6 mm sur un photorépéteur commercial actuel et que la tolérance est alors de 2 microns pour projeter des traits dont la largeur est de 1 micron.

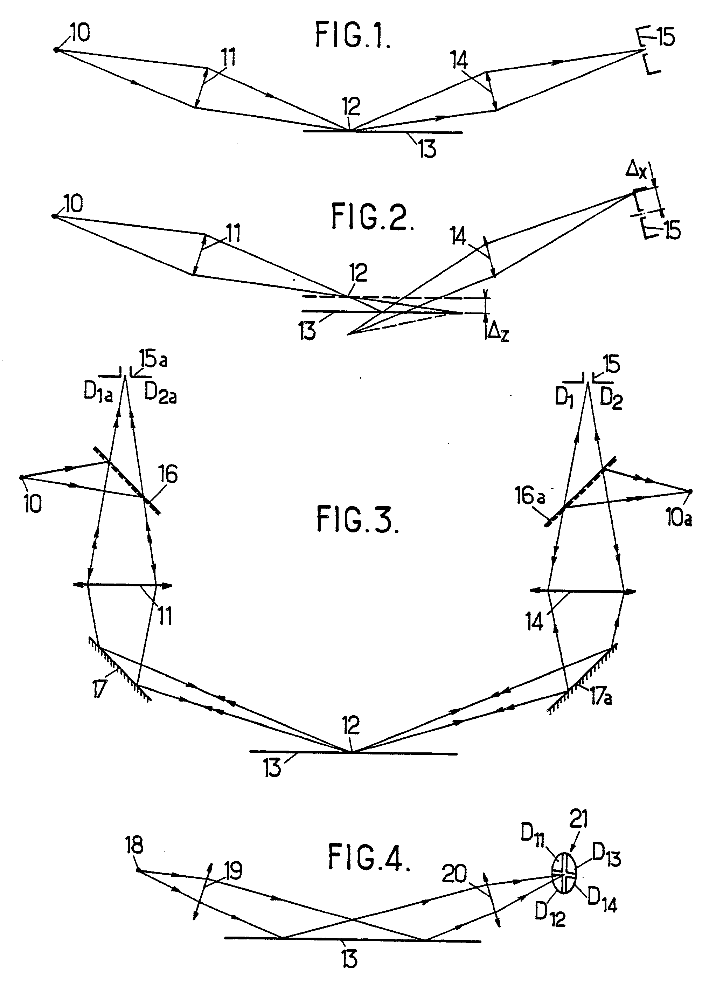

On connaît déjà des appareils de projection constituant photorépéteur du type ci-dessus défini, dont le dispositif de mise au point fonctionne de façon automatique. Un tel dispositif existe par exemple sur les photorépéteurs fabriqués par la société G.C.A. depuis 1977 au moins. La constitution et le fonctionnement de principe des moyens de détection sont illustrés sur les figures 1 et 2 ci-jointes. Les moyens comprennent une source 10 de lumière monochromatique associée à une lentille 11 qui forme de la source une image 12 qui se trouve sur la surface de la tranche 13 lorsque cette dernière est dans sa position nominale, comme indiqué sur la figure 1. Des moyens de reprise de la lumière, schématisés sous forme d'une lentille 14, forment de la tache de lumière sur la surface 13 une image qui, lorsque la tranche 13 est dans sa position nominale, est centrée par rapport à un photodétecteur différentiel 15, qui peut notamment être constitué soit par une diode à deux quadrants, soit par deux diodes séparées. On obtient ainsi par différence un signal d'erreur que l'on introduit dans une boucle d'asservissement.

Comme le montre la Figure 2, tout décalage en altitude $\Delta z$ de la tranche 13 provoque un décalage $\Delta x$ de l'image sur le photodétecteur différentiel 15, donc un signal d'erreur qui est une fonction croissante de $\Delta x$ et dont le signe dépend du sens de $\Delta z$.

Un tel dispositif de mise au point automatique peut être très sensible, surtout s'il utilise une incidence très oblique. Mais il présente un inconvénient grave. Une irrégularité de réflexion de la surface de la tranche 13 entraîne une asymétrie dans la répartition d'intensité de la tache et peut entraîner une erreur de mise au point.

On a tenté d'écarter cette difficulté en obligeant la lumière à suivre le même trajet dans un sens, puis dans l'autre, en remplaçant le photodétecteur 15 par un miroir de retour vers un détecteur placé à proximité de la source 10. Les moyens de détection des écarts comportent alors une source, par exemple une diode laser, une optique pour focaliser la lumière émise sous forme d'une tache, une optique comportant un miroir pour reprendre la lumière réfléchie et la renvoyer suivant un trajet opposé au trajet aller vers un détecteur d'écart. Cette solution, décrite notamment dans « Solid State Technology », juin 1980, pp. 80-84 et dans le document GB-A-2 052 090, est celle qui vient immédiatement à l'esprit. Mais elle n'est pas satisfaisante car le faisceau de retour a une intensité beaucoup plus faible que le faisceau aller, par suite des pertes d'absorption et de diffusion qui sont particulièrement importantes du fait de la grande incidence que doivent avoir les faisceaux sur la surface image. Les irrégularités de réflexion éventuelles de la surface image ne sont en conséquence nullement compensées. Cette solution n'est donc pas satisfaisante, car elle n'assure pas les compensations requises dans les conditions pratiques d'utilisation.

L'invention vise à fournir un appareil de projection du type ci-dessus défini, répondant mieux que ceux antérieurement connus aux exigences de la pratique, notamment en ce qu'il comporte un dispositif de mise au point automatique permettant d'écarter de façon simple les problèmes liés aux défauts de réflexion de la surface image.

Dans ce but, l'invention propose notamment un appareil dans lequel sont prévus deux jeux desdits moyens, correspondant à des trajets inverses de la lumière, et des moyens pour faire la somme des signaux différentiels fournis par les deux photodétecteurs.

Pour permettre de disposer de jeux de moyens correspondant à des trajets inverses, on utilisera en général des lames semi-transparentes de renvoi de lumière provenant de la source de l'un des jeux et de transmission de la lumière vers le photodétecteur de l'autre jeu.

Le dispositif de mise au point automatique comporte avantageusement de plus des moyens de détection des écarts angulaires, c'est-à-dire en assiette, entre la surface image et une position nominale. Ces moyens peuvent notamment comporter une source pour éclairer la surface par un faisceau parallèle en incidence oblique et des moyens pour focaliser l'image de la source sur un photodétecteur à quatre quadrants, le groupement des signaux de sortie des quatre quadrants

**0 063 980**

permettant d'obtenir des signaux d'erreur en assiette autour de deux axes perpendiculaires.

Enfin, l'invention vise par ailleurs à résoudre un problème particulier au cas des photorépéteurs. Quand on manipule des réticules ou masques en vue de les impressionner en plusieurs zones successives sur une tranche de semiconducteur, il est nécessaire de prendre des précautions pour éviter le dépôt sur ces réticules de particules dont l'image serait reproduite sur le circuit intégré. A l'heure actuelle, on connaît des appareils d'inspection de réticule par comparaison photométrique de deux zones homologues de motifs adjacents. Mais cette solution a de nombreux inconvénients. C'est en effet le réticule que l'on contrôle, et non pas l'image du réticule dans le plan de la tranche. Et, de plus, il existe un risque que des poussières se déposent pendant le transfert entre l'appareil de contrôle et le photorépéteur.

L'invention vise également à écarter cet inconvénient. Dans ce but, elle propose un appareil de projection constituant photorépéteur, comprenant des moyens de formation de deux zones homologues de motifs adjacents sur deux détecteurs photoélectriques et de mesure de la différence de signaux de sortie des deux détecteurs.

Cette solution est applicable chaque fois que plusieurs motifs élémentaires de circuit intégré figurent sur un même réticule, ce qui est fréquemment le cas étant donné que l'on réduit ainsi la durée de photorépétition sur tranche. On examine directement l'image réelle et non pas le réticule, ce qui permet de ne tenir compte que des défauts susceptibles d'être imprimés effectivement sur la tranche de silicium et d'accepter des réticules qui seraient rejetés sur un appareil classique d'inspection. La résolution de détection de défaut est du même ordre que la résolution de l'objectif, c'est-à-dire égale ou même inférieure au micron.

Les différents composants du dispositif peuvent occuper des positions très diverses par rapport à ceux qui servent directement à la projection. Par exemple, les moyens de détection d'écart angulaire peuvent utiliser un trajet de lumière faisant un angle, par exemple droit, avec les trajets de lumière dans lesdits jeux de moyens.

L'invention sera mieux comprise à la lecture de la description qui suit de modes particuliers de mise en œuvre de l'invention, donnés à titre d'exemples non limitatifs. La description se réfère aux dessins qui l'accompagnent, dans lesquels :

les figures 1 et 2 sont des schémas de principe montrant un jeu de moyens de détection d'écart suivant l'art antérieur, respectivement lorsque la surface image est dans sa position nominale et lorsqu'elle en est écartée ;

la figure 3 est un schéma de principe, similaire à la figure 1, montrant l'ensemble des moyens de détection d'un appareil suivant un premier mode de réalisation de l'invention, dans lequel seuls sont détectés les écarts en altitude ;

les figures 4 et 5 sont des schémas de principe similaires aux figures 1 et 2, montrant des moyens pouvant être associés à ceux de la figure 3 et permettant une détection des écarts angulaires, c'est-à-dire en assiette ;

la figure 6 est un schéma en plan, montrant la répartition et la constitution des photodétecteurs de moyens de détection des écarts en altitude et en assiette ;

la figure 7 est un schéma d'implantation des moyens dans un photorépéteur ;

la figure 7A montre une variante de la figure 7 ;

la figure 8 est un schéma de principe, en perspective, montrant l'implantation de moyens d'inspection de réticule pour appareil de projection constituant photorépéteur.

On décrira tout d'abord, en faisant référence à la figure 3, les moyens de détection des écarts en altitude entre la surface image 13, constituée par une tranche de silicium susceptible de présenter des défauts d'épaisseur et de planéité, et une position de référence.

Ces moyens sont entièrement symétriques et peuvent être regardés comme comportant deux jeux de moyens identiques. Le premier jeu (sur lequel les éléments correspondant à ceux de la figure 1 sont désignés par le même numéro de référence) comprend une source de lumière monochromatique 10 dont le faisceau de sortie est recueilli par une lame semi-transparente 16 dont le rôle apparaîtra plus loin. Le faisceau réfléchi par cette lame est focalisé par une lentille 11 et un miroir de renvoi 17 en une tache 12 qui se trouve sur la surface de la tranche 13 lorsque celle-ci occupe sa position nominale. Un miroir 17a symétrique du miroir 17 et une lentille 14 symétrique de la lentille 11 refocalisent la tache 12 sur un photodétecteur différentiel 15 à travers une lame semi-transparente 16a. Symétriquement, un système comportant la lame semi-transparente 16a, la lentille 14 et le miroir 17a forme de la source 10a une image confondue avec la tache 12. La lumière réfléchie par la surface 13 est reprise par le miroir 17, la lentille 11 et la lame semi-transparente 16 pour former une image sur un photodétecteur 15a similaire au photodétecteur 15.

Si l'on suppose que les photodétecteurs 15 et 15a comportent chacun deux quadrants, respectivement D1 et D2, D1a et D2a, le signal d'erreur sera :

$$(D1 - D2) + (D2a - D1a).$$

Les détecteurs seront évidemment placés et ajustés de façon que le signal de sortie, qui peut être élaboré par un circuit analogique additionneur classique, soit nul lorsque la surface 13 occupe sa position nominale.

Grâce à cette disposition, on élimine le problème rencontré en cas d'un seul passage de lumière : en effet, l'image d'une tache asymétrique sur le photodétecteur 15 sera également asymétrique de la même manière sur le photodétecteur 15a. Par ailleurs, les sources 10 et 10a peuvent sans inconvénient avoir des intensités légèrement différentes, car on utilise la moyenne des deux signaux photoélectriques.

A l'heure actuelle, les photorépéteurs comportent en général un dispositif de mise au point automatique, mais qui n'assure que la correction des écarts en altitude. La présente invention permet de réaliser aisément un contrôle de mise au point en assiette dont, jusqu'à présent, l'intérêt n'a pas été apprécié. En fait, une mise au point automatique en assiette est extrêmement souhaitable, car elle seule permet de corriger des défauts lents de planéité des tranches de silicium.

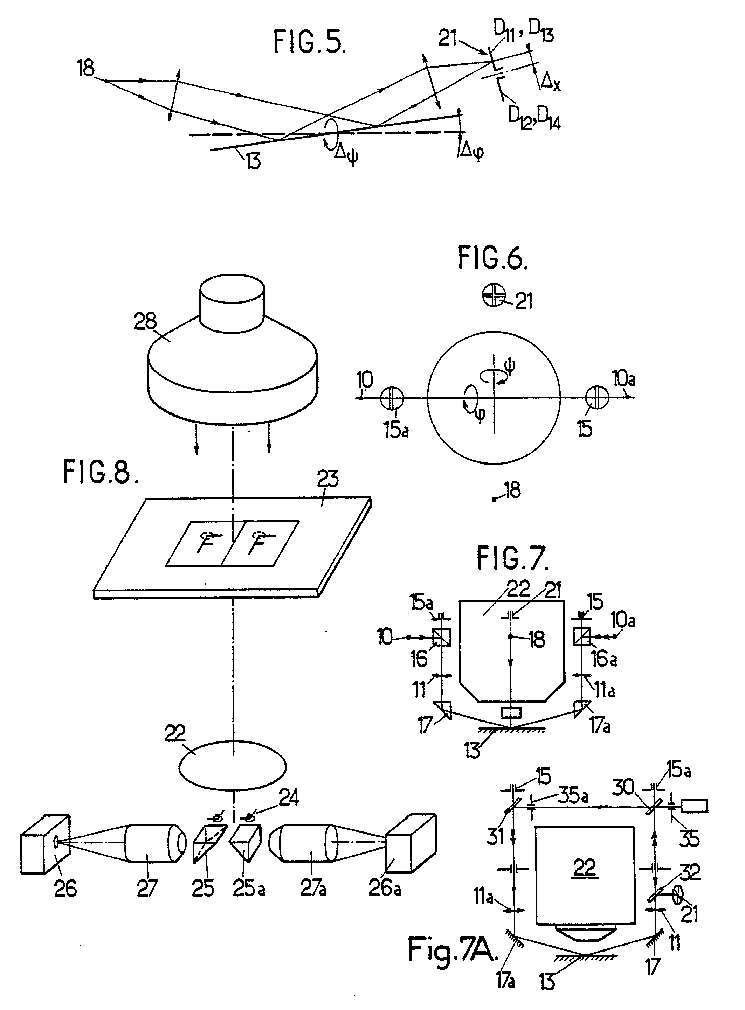

Les figures 4 et 5 montrent des moyens de détection d'écart en assiette qui peuvent être incorporés dans un appareil de projection pour fournir, à un dispositif de mise au point, les signaux d'entrée nécessaires à un réglage en assiette.

Les moyens montrés en figures 4 et 5 comprennent des moyens permettant d'envoyer, sur la tranche 13, un faisceau de lumière parallèle monochromatique, en incidence oblique. Ces moyens comprennent une source 18 et une optique schématisée par une lentille 19. Une seconde optique, également schématisée par une lentille 20, focalise l'image du point source 18 sur un photodétecteur quadruple 21 qui peut être constitué par une diode à quatre quadrants $D_{11}$, $D_{12}$, $D_{13}$ et $D_{14}$. Comme le montre la figure 5, un décalage en assiette $\Delta\phi$ autour d'un axe perpendiculaire au plan de la figure se traduit par un décalage $\Delta x$ sur le photodétecteur 21. Si l'on désigne par $D_{11}$, $D_{12}$, $D_{13}$ et $D_{14}$ les signaux de sortie des quatre quadrants, le signal d'erreur correspondant sera :

$$(D_{11} + D_{13}) - (D_{12} + D_{14}).$$

De façon similaire, tout décalage $\Delta\Psi$ en assiette autour d'un axe parallèle au plan de la figure se traduira par un signal d'erreur :

$$(D_{11} + D_{12}) - (D_{13} + D_{14}).$$

Les signaux d'erreur peuvent être injectés dans des boucles d'asservissement en $\phi$ et $\Psi$. On ne décrira pas ici ces boucles, pas plus que les dispositifs mécaniques de remise en position correcte, car elles peuvent être d'un type classique, tel par exemple que celui décrit dans « The Bell System Technical Journal », novembre 1970, pp. 2158-2160.

Il faut remarquer qu'un double passage de lumière suivant deux trajets opposés n'est pas nécessaire ici, car la refocalisation sur le photodétecteur s'accompagne d'une détermination de valeur moyenne.

Les moyens de détection d'écart en altitude et en assiette peuvent être situés autour de l'objectif d'un même photorépéteur, comme le montrent les figures 6 et 7 ; les trajets optiques des moyens de mesure d'écart en altitude et en assiette sont croisés et les trajets encadrent l'objectif 22. Les sources 15, 15a et 18 peuvent être constituées par des émetteurs indépendants mais d'intensité suffisante (diode laser par exemple) ou par les parties terminales de fibres optiques. Les miroirs de renvoi 17 et 17a ainsi que les lames semi-transparentes 16 et 16a sont constitués par des prismes.

En utilisant les lentilles 11 et 11a de focale 50 mm et un grandissement de dix, un défaut de mise au point en altitude $\Delta z = 2$ microns donne un déplacement du spot qui est approximativement de 40 microns. Un défaut d'assiette $\Delta\phi = 5$ microns/cm donnera, pour une focale de 50 mm, un déplacement du spot égal à 50 microns environ.

On voit que de tels déplacements sont aisément décelables à l'aide de photodétecteurs courants.

Dans la variante de réalisation montrée en figure 7A, où les organes correspondant à ceux de la figure 7 sont désignés par le même numéro de référence, on utilise une seule source 10 pour les contrôles de mise au point et d'assiette.

Le pinceau de lumière parallèle provenant de la source 10 (laser He-Ne par exemple) est fractionné par une lame séparatrice semi-transparente 30 en un faisceau réfléchi qui suit un premier trajet et un pinceau transmis dont la partie réfléchie par une seconde lame séparatrice 31 suit un second trajet, symétrique de premier lorsque la surface 13 de la tranche de silicium présente une assiette correcte. Les points sources sont constitués par des diaphragmes respectifs 35 et 35a dont l'image est formée, respectivement par les lentilles 11 et 11a, sur la surface 13. Les deux photodétecteurs différentiels 15 et 15a recueillent la lumière provenant de la tranche 13 et transmise respectivement à travers les lames 30 et 31.

Le contrôle d'assiette utilise une fraction du pinceau qui revient vers le photodétecteur 15a, fraction prélevée par réflexion sur une lame séparatrice semi-transparente 32 et renvoyée vers le photodétecteur 21, constitué en général par une diode à quatre quadrants. Cette diode est située au foyer de la lentille 11.

Ce système représente une simplification notable du précédent.

On décrira maintenant, en faisant référence à la figure 8, des moyens d'inspection de l'image du réticule qui peuvent être incorporés à un photorépéteur comprenant par ailleurs un dispositif de mise au point automatique du genre qui a été décrit plus haut.

La figure 8 montre schématiquement l'objectif de réduction 22 du photorépéteur qui permet de former, du réticule objet 23, une fois ce dernier en place dans le photorépéteur, une image réelle aérienne 24. L'inspection et la vérification s'effectuent par comparaison entre les zones homologues de deux motifs adjacents, ce qui ne constitue pas une limitatiion réelle, car des raisons de rapidité conduisent généralement à exposer plusieurs motifs à la fois. On peut noter au passage que le champ utile d'un photorépéteur est généralement de l'ordre de 1 cm × 1 cm et que l'invention sera donc utilisable chaque fois que la dimension unitaire de chaque motif ne dépasse pas 0,5 cm, ce qui est le cas le plus fréquent.

Les moyens d'inspection comprennent deux miroirs ou, comme illustré sur la figure 8, deux prismes à réflexion totale 25 et 25a en forme de demi-cube. Ces deux prismes envoient deux images homologues d'une petite surface du circuit intégré sur deux détecteurs photosensibles 26 et 26a par l'intermédiaire de deux objectifs de microscopes 27 et 27a. L'ensemble de ces éléments peut constituer un ensemble très compact, logé près de la tranche de silicium, sur un support solidarisé de la table xy qui porte la tranche.

Lorsque l'illuminateur 28 est allumé et provoque la formation des images montrées en tirets en 24, les signaux mesurés par les photodétecteurs 26 et 26a sont différents si les surfaces homologues, délimitées par des cercles sur la figure 8, n'ont pas la même transmission. La différence entre les deux signaux signale la présence d'un défaut opaque ou transparent sur l'une des deux images.

La surface vue par chaque détecteur photoélectrique 26 et 26a correspondra par exemple à un rectangle de 1 × 5 microns ou de 1 × 10 microns. On peut ainsi analyser l'image du réticule par balayage du type télévision, par lignes successives, larges de 5 microns ou 10 microns. L'opération complète de comparaison entre deux circuits de 5 × 5 mm conduit donc à balayer 1 000 lignes de largeur 5 microns et de longueur 5 mm, soit un parcours total de la table de 5 m. Le temps total de contrôle ne sera donc que de 100 secondes si le déplacement se fait à une vitesse moyenne de 5 cm/s. On voit que l'on ne réduit pas sensiblement le débit du photorépéteur du fait de l'inspection du réticule avant d'exposer un ou plusieurs lots de tranches.

Les moyens montrés en figure 8 peuvent être enregistrés avec leur position en mémoire d'un minicalculateur qui, en fin de contrôle, fournit la cartographie du circuit. Cette image du circuit aide à retrouver le défaut sous microscope et à le faire disparaître, si cela est possible, par exemple s'il s'agit d'une poussière. Il n'est pas nécessaire de décrire ici les moyens d'enregistrement en mémoire, étant donné qu'ils peuvent être classiques.

### Revendications

1. Appareil de projection sur une surface image (13) à l'aide d'une optique comportant un dispositif de mise au point muni d'un jeu de moyens de détection des écarts entre la surface image et une position nominale par rapport à l'optique, ce jeu ayant des moyens solidaires de l'optique pour former, sur ladite surface, une tache de lumière monochromatique en incidence oblique et des moyens de reprise de la lumière provenant de ladite surface pour former de la tache une image qui est centrée sur un photodétecteur différentiel lorsque la surface occupe sa position nominale par rapport à l'optique, caractérisé en ce que le dispositif comporte deux jeux desdits moyens (10-15 et 10a-15a) correspondant à des trajets inverses de la lumière et des moyens pour faire la somme des signaux différentiels fournis par les deux photodétecteurs.

2. Appareil suivant la revendication 1, caractérisé en ce qu'il comporte des lames semi-transparentes (16, 16a) de renvoi de lumière provenant de la source (10, 10a) de l'un des jeux et de transmission de la lumière vers le photodétecteur de l'autre jeu (15, 15a).

3. Appareil suivant la revendication 1 ou 2, caractérisé en ce qu'il comprend des moyens de détection des écarts angulaires entre la surface image et une position nominale, lesdits moyens comportant une source (18, 19) dirigeant vers la surface (13) un faisceau de lumière parallèle en incidence oblique, des moyens pour focaliser la lumière réfléchie sur un détecteur à quatre quadrants (21) et des moyens pour former, à partir des signaux de sortie du détecteur, des signaux d'écart autour de deux axes perpendiculaires.

4. Appareil suivant la revendication 3, caractérisé en ce que les moyens de détection d'écart angulaire (18-19-21) utilisent un trajet de lumière faisant un angle, par exemple droit, avec les trajets de lumière dans lesdits jeux de moyens (10-15 et 10a-15a).

5. Appareil de projection suivant l'une quelconque des revendications précédentes, constituant photorépéteur sur tranche, caractérisé en ce que, pour permettre l'examen à l'emplacement d'insolation, lesdits moyens sont placés autour de l'objectif (22) du photorépéteur.

6. Appareil de projection constituant photorépéteur, suivant l'une quelconque des revendications précédentes, caractérisé en ce qu'il comprend des moyens (25, 27 et 25a, 27a) de formation de deux zones homologues de motifs adjacents sur deux détecteurs photoélectriques (26, 26a) et de mesure de la différence des signaux de sortie des deux détecteurs.

### Claims

1. Apparatus for imaging onto an image surface (13) with an optical system having a focussing device provided with a set of means for detection of deviations between the image surface and a set position with respect to the optical system, said set having means for forming a spot of monochromatic light onto said surface under a large angle of incidence and means for collecting the light from said surface for forming an image of the spot which is centered on a differential light detector when said surface is in its set position with respect to the optical system, characterized in that the device comprises two sets of said means (10-15 and 10a-15a) corresponding to reverse paths of the light and means for summing the differential signals delivered by the two light detectors.

2. Apparatus according to claim 1, characterized in that it comprises semi-transparent strips (16, 16a) for reflecting light from the source (10, 10a) of one of said sets and for transmitting light toward the light detector of the other set (15, 15a).

3. Apparatus according to claim 1 or 2, characterized in that it comprises means for detecting angular deviations between said image surface and a set position, said means comprising a source (18, 19) for directing a parallel light beam toward said surface (13) under a large angle of incidence, means for focussing the reflected light onto a four-quadrant detector (21) and means for generating signals representative of the deviations about two mutually orthogonal axes from the output signals of said detector.

4. Apparatus according to claim 3, characterized in that the means for detecting angular deviations (18-19-21) make use of a light path which is at an angle, for instance a square angle, with the light paths in said two sets of means (10-15 and 10a-15a).

5. Apparatus according to any one of the preceding claims, constituting a « step and repeat » wafer imaging device, characterized in that, for authorizing examination at the place where illumination occurs, said means are located around the objective lens (22) of the « step and repeat » wafer imaging device.

6. Apparatus according to any one of the preceding claims, constituting a « step and repeat » wafer imaging device, characterized in that it comprises means (25, 27 and 25a, 27a) for forming images of two corresponding zones of adjacent patterns on two photoelectric detectors (26, 26a) and for measuring the difference between the output signals of the two detectors.

**Patentansprüche**

1. Vorrichtung zur Projektion auf eine Bildfläche (13) mit Hilfe einer Optik, die eine Einstellvorrichtung mit einem Satz von Mitteln zur Wahrnehmung der Unterschiede zwischen der Bildfläche und einer nominalen Position in Bezug auf die Optik aufweist, wobei der Satz mit der Optik verbundene Mittel aufweist, um auf der genannten Oberfläche in schrägem Einfall einen monochromatischen Lichtfleck zu erzeugen, und Mittel zur Aufnahme des Lichtes aufweist, das von jener Oberfläche herrührt, um mit dem Lichtfleck ein Bild zu erzeugen, welches auf einem differenziellen Fotodetektor zentriert ist, bis die Fläche ihre Nominalposition in Bezug auf die Optik einnimmt, dadurch gekennzeichnet, daß die Einrichtung zwei Sätze der genannten Mittel (10-15 und 10a-15a) entsprechend der umgekehrten Wegverläufe des Lichtes, und Mittel, um die Summe der Differenzialsignale zu bilden, die von den beiden Fotodetektoren geliefert werden, aufweist.

2. Vorrichtung nach Anspruch 1, dadurch gekennzeichnet, daß sie semitransparente Tafeln (16, 16a) zum Zurückwerfen des Lichtes, welches von einer Quelle (10, 10a) eines der Sätze herrührt und zur Transmission des Lichtes zum Fotodetektor des anderen Satzes (15, 15a), aufweist.

3. Vorrichtung nach Anspruch 1 oder 2, dadurch gekennzeichnet, daß sie Mittel zur Bestimmung von Winkelunterschieden zwischen der Bildoberfläche und einer Nominalposition aufweist, wobei diese Mittel eine Quelle (18, 19) aufweisen, die auf die Oberfläche (13) ein Bündel parallelen Lichtes in schrägem Einfall leiten, und daß sie Mittel zum Bündeln von auf einen Detektor mit vier Quadranten (21) reflektierten Lichtes und Mittel zum Formen ; neben den Signalen am Ausgang des Detektors, von Unterschiedssignalen um zwei rechtwinklig angeordnete Achsen aufweist.

4. Vorrichtung nach Anspruch 3, dadurch gekennzeichnet, daß die Aufspürmittel der Winkelunterschiede (18-19-21) einen Lichtverlauf benutzen, der einen Winkel z. B. einen rechten, mit dem Lichtverlauf aus den genannten Sätzen von Mitteln (10-15 und 10a-15a) bildet.

5. Vorrichtung nach einem der vorangehenden Ansprüche, einen Fotoverstärker auf einer Scheibe (13) bildend, dadurch gekennzeichnet, daß zur Prüfung von Isolationsstellen die genannten Mittel um das Objektiv (22) des Fotoverstärkers herum angeordnet sind.

6. Vorrichtung, einen Fotoverstärker bildend, nach einem der vorangehenden Ansprüche, dadurch gekennzeichnet, daß sie Mittel (25, 27 und 25a, 27a) zur Bildung zweier benachbarter, sich im Motiv entsprechender Zonen auf zwei fotoelektrischen Detektoren (26, 26a) und zur Messung des Unterschiedes der Signale am Ausgang dieser beiden Detektoren aufweist.

FIG.1.

FIG.2.

FIG.3.

FIG.4.

FIG.5.

FIG.6.

FIG.8.

FIG.7.

Fig.7A.